# EUROPEAN PATENT APPLICATION

(11) **EP 1 699 076 A1**
(43) Date of publication of application: **06.09.2006**
(21) Application number: 04819806.3
(22) Date of filing: 29.11.2004
(51) Int. Cl.: H01L 21/3065

(54) **PLASMA GENERATOR AND PLASMA ETCHING DEVICE**

(30) Priority: 02.12.2003 JP 2003403616
(71) Applicant: SUMITOMO PRECISION PRODUCTS COMPANY LIMITED, Amagasaki-shi, Hyogo Prefecture 660-0891 (JP)
(72) Inventor: HAYASHI, Yasuyuki, (JP); MURAKAMI, Shoichi, (JP); HABE, Takeshi, (JP); IKEMOTO, Naoya, (JP)
(74) Representative: de Beaumont, Michel
(86) International application number: PCT/JP2004/017725
(87) International publication number: WO 2005/055304

(57) **Abstract**

The present invention provides a plasma generator capable of generating plasma so that the etching rate is uniform in the circumferential direction of a sample, and a plasma etching apparatus capable of carrying out uniform etching processing in the circumferential direction of the sample. While a process gas is introduced into a plasma generating chamber and while a predetermined pressure is maintained, a high-frequency AC voltage is applied to a coil to generate the plasma of the process gas. By the application of an AC voltage to a substrate electrode, the plasma generated inside the plasma generating chamber is introduced into a reaction chamber, and the sample is etched. The coil is not wound in a uniform spiral, but one turn of the coil has a first winding region in which the coil is wound horizontally or nearly horizontally and a second winding region in which the coil is wound so as to have a steep inclination.

## Description

### TECHNICAL FIELD

The present invention relates to a plasma generator that generates plasma inside a cylinder on which a coil is wound, and to a plasma etching apparatus that carries out dry etching on samples using the plasma.

### BACKGROUND ART

Conventionally, dry etching processing that uses plasma has been used widely as a method for etching silicon films, dielectric films, etc. formed on semiconductor substrates (for example, see Patent documents 1 through 3). In dry etching processing that uses plasma, the plasma of a low-pressure process gas is generated under reduced pressure, and samples are etched using the generated plasma. For example, in an inductively-coupled plasma apparatus that controls plasma generation and plasma introduction independently, an AC voltage is applied to a coil to generate plasma, an AC voltage is applied to a substrate electrode on which a sample is placed, to introduce the generated plasma, and etching is carried out using the introduced plasma.

As a plasma generating method in the plasma etching apparatus described above, a method is known in which plasma is assumed to be a single turn lossy conductor, the conductor is coupled to a nonresonant high-frequency coil wound multiply around a discharge chamber made of a dielectric, and high-frequency power is inductively coupled to the plasma using transformer operation. In this inductively-coupled plasma generating method, high-density plasma can be generated using a configuration of relatively low cost.

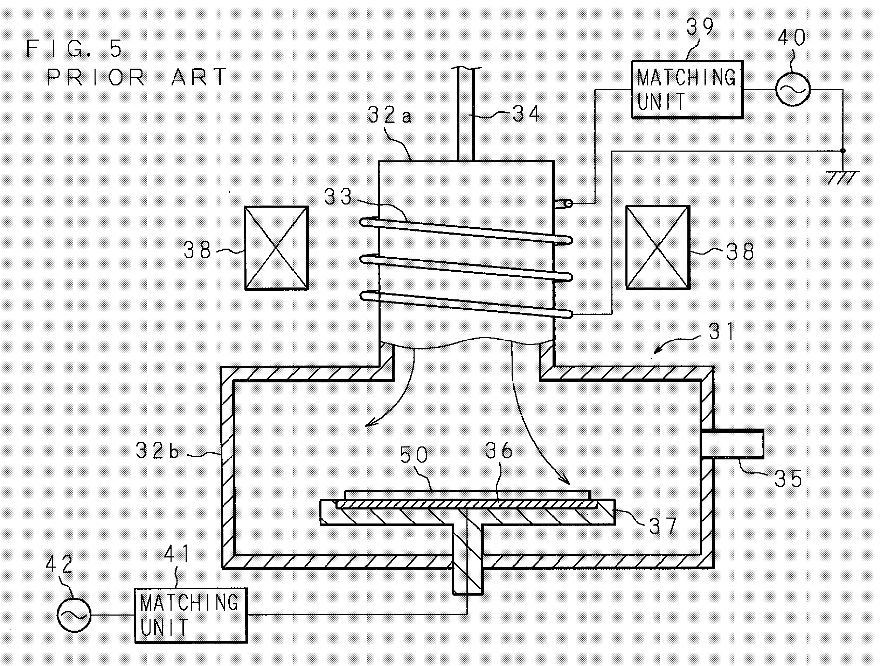

FIG. 5 is a view showing the configuration of the above-mentioned conventional plasma etching apparatus. In FIG. 5, numeral 31 designates a reactor, and the reactor 31 comprises a plasma generating chamber 32a that is located on the upper side and generates plasma, and a reaction chamber 32b that is located on the lower side and carries out plasma processing on a sample 50 by introducing the generated plasma.

Multiple turns of a coil 33 are concentrically wound uniformly and spirally around the outer face of the plasma generating chamber 32a having a cylindrical shape. A high-frequency AC power source 40 is connected to the coil 33 via a matching unit 39. In addition, a DC magnetic field generating coil 38 is provided around the circumference of the plasma generating chamber 32a. Furthermore, a gas introducing pipe 34 that introduces a process gas into the reactor 31 is communicated with the plasma generating chamber 32a.

A platen 37 having a substrate electrode 36 on which the sample 50 to be etched is placed is disposed at the bottom of the reaction chamber 32b. A high-frequency AC power source 42 is connected to the substrate electrode 36 via a matching unit 41. Furthermore, an exhaust port 35 is open in the reaction chamber 32b.

In the plasma etching apparatus configured as described above, a high-frequency AC voltage is applied to the coil 33 while a predetermined pressure is maintained inside the plasma generating chamber 32a by introducing a process gas from the gas introducing pipe 34 into the plasma generating chamber 32a and by evacuating the reactor 31 via the exhaust port 35. Hence, the plasma of the process gas is generated and maintained. The plasma is spread in a direction perpendicular to the axis of the plasma generating chamber 32a by passing a DC current through the DC magnetic field generating coil 38. Then, by the application of an AC voltage to the substrate electrode 36, the plasma generated inside the plasma generating chamber 32a is introduced into the reaction chamber 32b, and the sample 50 is etched using the introduced plasma.

Patent document 1: Japanese Patent Application Laid-Open No. 7-320894

Patent document 2: Japanese Patent Application Laid-Open No. 10-270193

Patent document 3: Japanese Patent Application Laid-Open No. 2000-30893

### DISCLOSURE OF THE INVENTION

In the conventional plasma etching apparatus configured as described above, the coil 33 is wound uniformly and spirally around the circumference of the plasma generating chamber 32a having a cylindrical shape. Hence, the etching rate differs in the circumferential direction of the sample 50, and this configuration has a problem of being unable to carry out uniform etching processing.

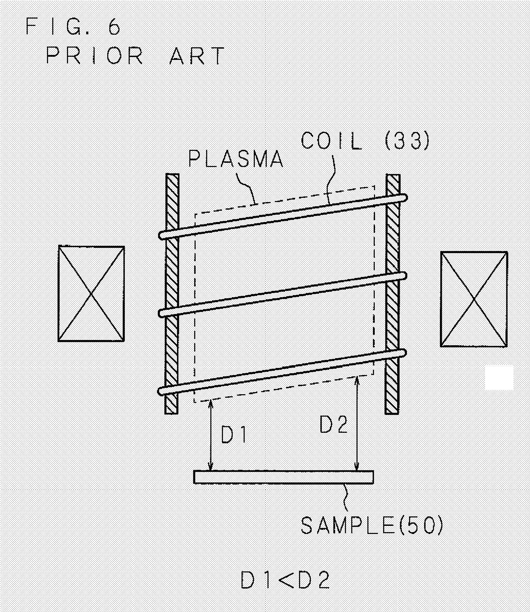

FIG. 6 is a view showing the positional relationship between the plasma generator (the coil 33) and the sample 50 in this conventional example. Because the coil 33 is wound uniformly and spirally, the distance (D1, D2) between the sample 50 and the plasma generating region indicated by broken lines differs in the circumferential direction of the sample 50 (D1 < D2). As a result, in a region of the sample 50 in which the distance (D1) is short, the etching rate is high, and in another region of the sample 50 in which the distance (D2) is long, the etching rate is low. Therefore, the rate of etching the sample 50 is nonuniform in the circumferential direction. As a result, it is impossible to carry out uniform etching in the circumferential direction.

The coil 33 is required to be wound at a predetermined pitch or more so that no discharge occurs between the adjacent wires of the coil 33. For this reason, in the case that the coil 33 is wound uniformly and spirally, it is inevitable that the distance between the plasma generating region and the sample 50 differs in the circumferential direction as described above.

In consideration of the circumstances described above, the present invention is intended to provide a plasma generator capable of generating plasma so that the etching rate is uniform in the circumferential direction of a sample, and to provide a plasma etching apparatus capable of carrying out uniform etching processing in the circumferential direction of the sample using this plasma generator.

A plasma generator according to a first aspect, comprising a cylinder and a coil wound around the circumference of the cylinder, a process gas being introduced into the cylinder, an AC current being passed through the coil, and the plasma of the process gas being generated inside the cylinder, wherein, in one turn of the coil, at least two kinds of angles are formed between the winding direction of the coil and the face perpendicular to the axis of the cylinder, and a first winding region having the angle within a predetermined range and a second winding region having the angle larger than the maximum angle of the first winding region are provided.

In the first aspect, the coil is not wound in a uniform spiral around the outer circumference of the cylinder (the plasma generating chamber), in other words, the angle formed between the winding direction and the face perpendicular to the axis of the cylinder (the plasma generating chamber) is not uniform in the whole region in the circumferential direction, but the coil is wound around the outer circumference of the cylinder (the plasma generating chamber) so as to have the first winding region having the angle within the predetermined range and the second winding region having the angle larger than the maximum angle of the first winding region. In this case, it is preferable that the angle of the first winding region should be as small as possible, and it is most preferable that the coil should be wound horizontally.

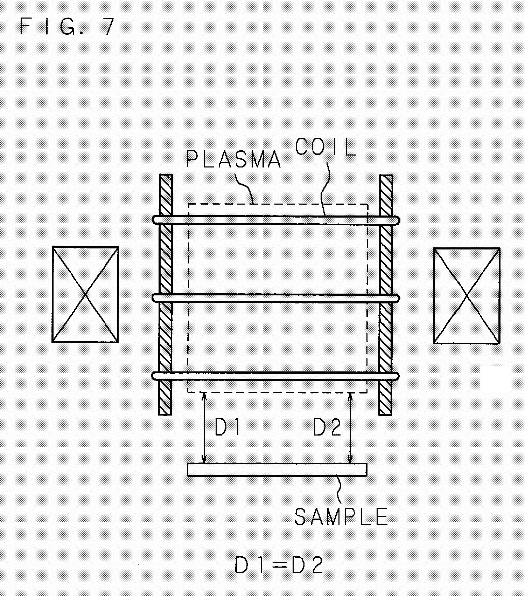

FIG. 7 is a view showing the positional relationship between the plasma generator (the coil) and the sample in an embodiment of the present invention. In the case that the coil is wound horizontally, the distance (D1, D2) between the sample and the plasma generating region indicated by broken lines is identical in the circumferential direction of the sample (D1 = D2). As a result, the etching rate in the circumferential direction of the sample is identical, and the etching processing on the sample becomes uniform in the circumferential direction.

A plasma generator according to a second aspect is characterized in that the predetermined range in the first aspect is 1.5 degrees or less in absolute value.

In the second aspect, the predetermined range is 1.5 degrees or less in absolute value so that the winding direction in the first winding region is as horizontal as possible. Hence, there is almost no difference in the etching rate in the circumferential direction of the sample.

A plasma generator according to a third aspect is characterized in that the ratio of the first winding region in the whole circumference of the cylinder in the first aspect is 75% or more.

In the third aspect, the ratio of the first winding region is 75% or more so that the first winding region being horizontal or nearly horizontal is made as large as possible. Hence, the region in which there is no difference in the etching rate is made wider.

A plasma generator according to a fourth aspect is characterized in that the winding pitch of the coil is not less than the distance at which no discharge occurs between the adjacent wires of the coil in any one of the first to third aspects.

In the fourth aspect, a sufficient pitch distance at which no discharge occurs between the adjacent wires of the coil is obtained by providing the second winding region in which the coil is wound so as to have a steep inclination.

A plasma etching apparatus for etching a sample using plasma according to a fifth aspect is characterized in that the apparatus comprises the plasma generator according to any one the first to fourth aspects, wherein the plasma of the process gas, generated in the plasma generator, is used.

In the fifth aspect, the distance between the plasma generating region and the sample is identical in the circumferential direction of the sample. Hence, the etching rate is identical in the circumferential direction of the sample, and a uniform etched shape is obtained.

In the plasma generator according to the present invention, the angle formed between the winding direction and the face perpendicular to the axis of the cylinder (the plasma generating chamber) is not uniform, but the coil is wound horizontally or nearly horizontally around the outer circumference of the cylinder (the plasma generating chamber). Hence, the distance between the plasma generating region and the sample can be made identical or nearly identical in the circumferential direction of the sample. Therefore, in the case that this plasma generator is used for the plasma etching apparatus, the etching rate in the circumferential direction of the sample can be made identical, and an etched shape being uniform in the circumferential direction can be obtained.

In the plasma generator according to the present invention, the predetermined range is 1.5 degrees or less in absolute value. Hence, the coil winding direction in the first winding region can be made horizontal or nearly horizontal, and the above-mentioned effect of the present invention can be produced.

In the plasma generator according to the present invention, the ratio of the first winding region is 75% or more. Hence, the region in which the coil is wound horizontally or nearly horizontally can be made large, and the above-mentioned effect of the present invention can be produced.

In the plasma generator according to the present invention, the second winding region in which the coil is wound so as to have a steep inclination is provided. Hence, a sufficient coil pitch distance can be obtained, and discharge can be prevented between the adjacent wires of the coil.

In the plasma etching apparatus according to the present invention, plasma that is generated so that the distance between the plasma generating region and the sample is identical in the circumferential direction of the sample is used. Hence, the etching rate in the circumferential direction of the sample can be made uniform, and a uniform etched shape can be obtained.

### BRIEF DESCRIPTION OF THE DRAWINGS

FIG. 1 is a view showing the configuration of a plasma etching apparatus in which a plasma generator according to the present invention is used;
FIG. 2 is a view showing the measurement positions of the etching rate in a sample;
FIGS. 3(a) and 3(b) are a table and a graph showing the measurement results of the etching rate at the time when samples are etched using the conventional plasma etching apparatus;
FIGS. 4(a) and 4(b) are a table and a graph showing the measurement results of the etching rate at the time when samples are etched using the plasma etching apparatus according to the present invention;
FIG. 5 is a view showing the configuration of the plasma etching apparatus in which the conventional plasma generator is used;
FIG. 6 is a view showing the positional relationship between the plasma generator (the coil) and the sample in the case that the conventional plasma generator is used; and
FIG. 7 is a view showing the positional relationship between the plasma generator (the coil) and the sample in the case that the plasma generator according to the present invention is used.

### EXPLANATION OF REFERENCE NUMERALS

- 1: reactor
- 2a: plasma generating chamber
- 2b: reaction chamber
- 3: coil
- 3a: first winding region
- 3b: second winding region
- 4: gas introducing pipe
- 8: DC magnetic field generating coil
- 9: matching unit
- 10: AC power source
- 20: sample

### BEST MODE FOR IMPLEMENTING THE INVENTION

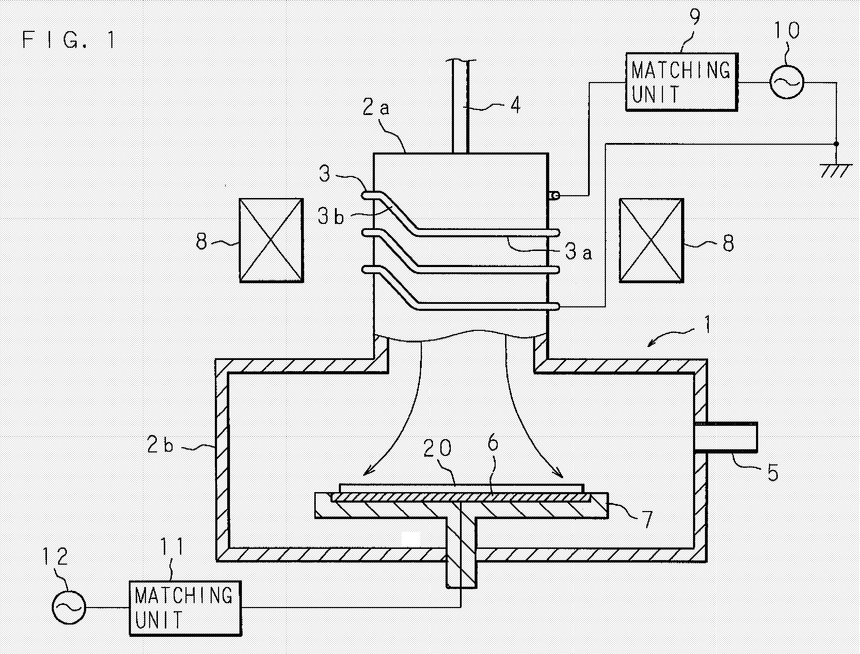

The present invention will be described below specifically on the basis of the drawings showing an embodiment thereof. FIG. 1 is a view showing the configuration of a plasma etching apparatus in which a plasma generator according to the present invention is used. In FIG. 1, numeral 1 designates a reactor, and the reactor 1 comprises a plasma generating chamber 2a that is located on the upper side and generates plasma by energizing a coil 3, and a reaction chamber 2b that is located on the lower side and carries out plasma processing on a sample 20 by introducing the generated plasma.

Multiple turns (for example, three turns) of the coil 3 are wound nonuniformly around the outer face of the plasma generating chamber 2a having a cylindrical shape. The winding form of this coil 3 will be detailed later. A high-frequency AC power source 10 is connected to the coil 3 via a matching unit 9. In addition, a DC magnetic field generating coil 8 is provided around the circumference of the plasma generating chamber 2a to spread the plasma in a direction perpendicular to the axis of the plasma generating chamber 2a. Furthermore, a gas introducing pipe 4 that is connected to a process gas source (not shown) so as to introduce a process gas into the reactor 1 is communicated with the plasma generating chamber 2a.

An exhaust port 5 connected to an exhaust apparatus (not shown) is open in the reaction chamber 2b. A platen 7 having a substrate electrode 6 on which the sample 20 to be etched is placed is disposed at the bottom of the reaction chamber 2b. A high-frequency AC power source 12 is connected to the substrate electrode 6 via a matching unit 11.

In the plasma etching apparatus configured as described above, a high-frequency AC voltage is applied to the coil 3 while a predetermined pressure is maintained inside the plasma generating chamber 2a by introducing a process gas from the gas introducing pipe 4 into the plasma generating chamber 2a and by evacuating the reactor 1 via the exhaust port 5. Hence, the plasma of the process gas is generated and maintained. At this time, the plasma is spread in a direction perpendicular to the axis of the plasma generating chamber 2a by passing a DC current through the DC magnetic field generating coil 8. Then, by the application of an AC voltage to the substrate electrode 6, the plasma generated inside the plasma generating chamber 2a is introduced into the reaction chamber 2b, and the sample 20 is etched using the introduced plasma.

The plasma generator according to the present invention shown in FIG. 1 and the above-mentioned conventional plasma generator shown in FIG. 5 are similar to each other in the basic configuration, and they are identical to each other in the principle of plasma generation. However, they are significantly different from each other in the winding form of the coil wound around the plasma generating chamber. If the coil is wound too closely, discharge will occur between the adjacent wires of the coil. Therefore, it is necessary to wind the coil so that the adjacent wires thereof are separated from each other by a predetermined distance or more.

In the conventional example shown in FIG. 5, the coil 33 is wound around the circumference of the plasma generating chamber 32a uniformly and spirally. Hence, the angle formed between the face perpendicular to the axis of the plasma generating chamber 32a and the winding direction of the coil 33 is identical at any positions.

On the other hand, in this embodiment of the present invention shown in FIG. 1, the coil 3 is not wound in a uniform spiral, but one turn thereof has a first winding region 3a in which the coil 3 is wound in a horizontal or nearly horizontal direction and a second winding region 3b in which the coil 3 is wound so as to have an inclination larger than that of the first winding region 3a. In other words, in the first winding region 3a, the coil 3 is wound so that the angle formed between the face perpendicular to the axis of the plasma generating chamber 2a and the winding direction of the coil 3 is within a predetermined range. In the second winding region 3b, the coil 3 is wound at an inclination larger than the angle. The ratio of the first winding region 3a in the whole circumference of the plasma generating chamber 2a is larger than that of the second winding region 3b.

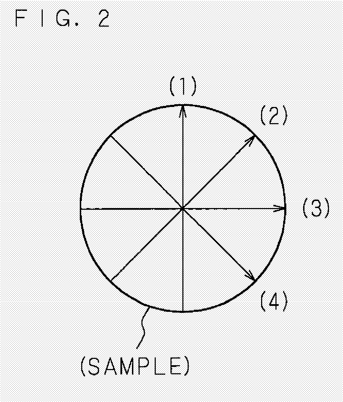

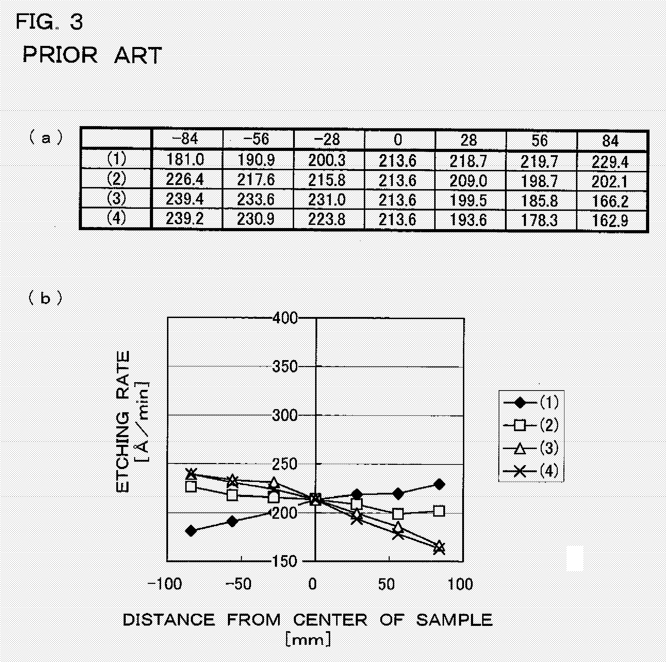

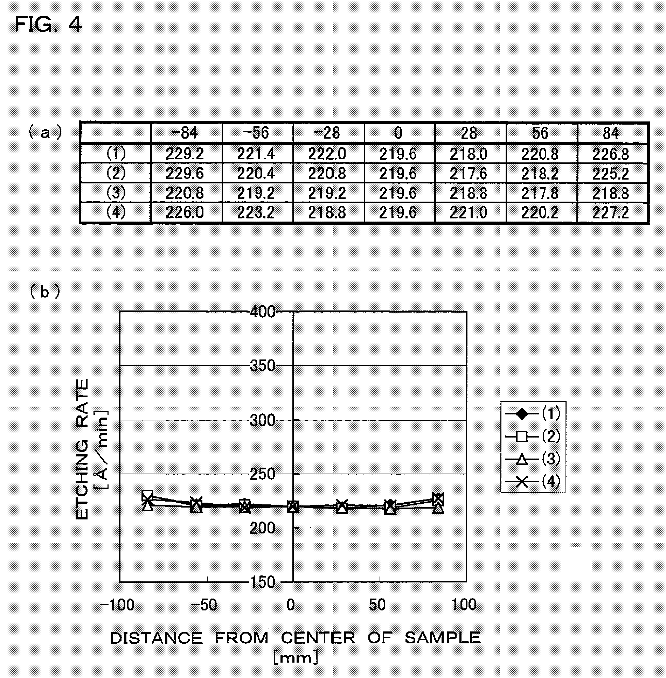

Next, the measurement results of the etching rate at the time when samples were etched using the conventional example shown in FIG. 5 and the embodiment according to the present invention shown in FIG. 1 will be described below. The same samples having a diameter of 200 mm were used, and the etching rate was measured in the four diametric directions indicated by arrows in FIG. 2. FIGS. 3(a) and 3(b) show the measurement results in the case of the conventional example, and FIGS. 4(a) and 4(b) show the measurement results in the case of the embodiment of the present invention. FIGS. 3(a) and 4(a) are tables showing the measured values of the etching rate. The values in the top column represent distances (the direction of the arrow in FIG. 2 indicates a positive direction: mm) from the center of the sample. The numerals in parentheses in the left column represent the measurement directions (the four directions in FIG. 2). Furthermore, FIGS. 3(b) and 4(b) are graphs showing the measured values of the etching rate. The horizontal axis represents the distance (the direction of the arrow in FIG. 2 indicates a positive direction: mm) from the center of the sample, and the vertical axis represents the etching rate (Å/min).

As being understood from the measurement results shown in FIGS. 3(a) and 3(b), the difference in the etching rate in the circumferential direction of the sample is significant in the conventional example. This is caused by the fact that the coil 33 is wound uniformly and spirally at a pitch of a predetermined distance or more to prevent discharge, whereby the distance between the plasma generating region and the sample differs in the circumferential direction of the sample as shown in FIG. 6. Because the etching rate varies in the circumferential direction of the sample as described above in the conventional example, the etched form becomes nonuniform in the circumferential direction.

As being understood from the measurement results shown in FIGS. 4(a) and 4(b), the difference in the etching rate in the circumferential direction of the sample is almost insignificant in the embodiment of the present invention. This is obtained by the fact that the coil 3 is wound so that the horizontal or nearly horizontal region (the first winding region 3a) ranges extensively at a pitch of a predetermined distance or more to prevent discharge, whereby the distance between the plasma generating region and the sample is identical in the circumferential direction of the sample as shown in FIG. 7. Because the etching rate is uniform in the circumferential direction of the sample as described above in the embodiment of the present invention, the etched form being uniform in the circumferential direction can be obtained.

The winding form of the coil 3 according to the present invention shown in FIG. 1 will be described further. In the present invention, ideally, it is preferable that the coil 3 should be wound horizontally in the first winding region 3a, in other words, it is preferable that the angle formed between the face perpendicular to the axis of the plasma generating chamber 2a and the winding direction of the coil 3 should be 0 degrees. It is also preferable that the inclination of the coil 3 in the second winding region 3b should be as steep as possible to obtain the distance for avoiding the influence of discharge within a small range. In this case, the ratio of the first winding region 3a in the whole circumference is nearly 100%. Although the above-mentioned angle is ideally 0 degrees, in the case that the predetermined range of the angle is 1.5 degrees or less in absolute value, it is possible to obtain an effect similar to that obtained when the angle is 0 degrees. Furthermore, in the case that the ratio of the first winding region 3a in the whole circumference is 75% or more, the effect peculiar to the present invention can be produced.

In the above-mentioned embodiment, the winding form (horizontality) of the coil 3 in the first winding region 3a is determined by the angle formed between the face perpendicular to the axis of the plasma generating chamber 2a and the winding direction of the coil 3. However, the winding form (horizontality) of the coil 3 in the first winding region 3a may also be determined according to the amount of the movement in the direction of the height in one turn of the coil 3. In this case, in the case that the amount of the movement in the direction of the height in the first winding region 3a in one turn of the coil 3 is 10 mm or less, the above-mentioned effect peculiar to the present invention can be obtained.

In addition, in the above-mentioned embodiment, the case in which each one of the first winding region 3a and the second winding region 3b is provided in one turn of the coil 3 is described. However, multiple first winding regions 3a being horizontal or nearly horizontal and/or multiple second winding regions 3b having a large inclination may also be provided in one turn of the coil 3. Furthermore, although the angle formed between the face perpendicular to the axis of the plasma generating chamber 2a and the winding direction of the coil 3 in each of the first winding region 3a and the second winding region 3b is set to have a single uniform value, multiple different kinds of angles may also be used in the first winding region 3a and/or the second winding region 3b. However, in this case, the angles in the second winding region 3b are larger than the maximum angle in the first winding region 3a.

## Claims

1. A plasma generator, comprising a cylinder (2a) and a coil (3) wound around the circumference of said cylinder (2a), a process gas being introduced into said cylinder (2a), an AC current being passed through said coil (3), and the plasma of the process gas being generated inside said cylinder (2a), **characterized in that** in one turn of said coil (3), at least two kinds of angles are formed between the winding direction of said coil and the face perpendicular to the axis of said cylinder (2a), and that a first winding region (3a) having said angle within a predetermined range and a second winding region (3b) having said angle larger than the maximum angle of said first winding region (3a) are provided.

2. The plasma generator according to claim 1, wherein said predetermined range is 1.5 degrees or less in absolute value.

3. The plasma generator according to claim 1, wherein the ratio of said first winding region (3a) in the whole circumference of said cylinder (2a) is 75% or more.

4. The plasma generator according to any one of claims 1 to 3, wherein the winding pitch of said coil (3) is not less than the distance at which no discharge occurs between the adjacent wires of said coil (3).

5. A plasma etching apparatus for etching a sample (20) using plasma, **characterized in that** the plasma generator according to any one of claims 1 to 4 is provided, and that the plasma of the process gas, generated in the plasma generator, is used.
